**Europäisches Patentamt**

**European Patent Office**

**Office européen des brevets**

(19)

(11) Publication number : **0 442 162 B1**

# (12) EUROPEAN PATENT SPECIFICATION

(45) Date of publication of patent specification :
16.06.93 Bulletin 93/24

(51) Int. Cl.⁵ : **C23C 14/14, C23C 14/58, C23C 8/08, C23C 8/36**

(21) Application number : **90203447.9**

(22) Date of filing : **20.12.90**

(54) **Film of titanium hydride.**

(30) Priority : **16.02.90 IT 1939090**

(43) Date of publication of application :
**21.08.91 Bulletin 91/34**

(45) Publication of the grant of the patent :
**16.06.93 Bulletin 93/24**

(84) Designated Contracting States :
**AT BE CH DE DK ES FR GB GR LI LU NL SE**

(56) References cited :
**EP-A- 0 340 077**
**FR-A- 2 585 730**
**US-A- 4 055 686**

(73) Proprietor : **ENIRICERCHE S.p.A.**
**Corso Venezia 16**
**I-20121 Milan (IT)**

(72) Inventor : **Boccalon, Gianfranco**
**deceased (IT)**
Inventor : **Grillo, Giovanni**
**Via Marx 112,**
**I-00137 Rome (IT)**
Inventor : **Vittori, Vittorio**
**Via Monte del Tiro 31**
**I-00013 Mentana-Rome (IT)**

(74) Representative : **Roggero, Sergio et al**
**Ing. Barzanò & Zanardo Milano S.p.A. Via**
**Borgonuovo 10**
**I-20121 Milano (IT)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 442 162 B1

## Description

The present invention discloses a method for producing hydrogenated, homogeneous and stable films of titanium or of other metals, which films contain large amounts of hydrogen, on a substrate, which can be a conductor, a semiconductor or an insulating material.

Films of titanium containing suitable hydrogen isotopes have been applied as neutron generators, or as neutron energy moderators.

Hydrogenated titanium can be useful as a protective, anticorrosion coating endowed with barrier properties to $H_2$ diffusion, in order to supply a higher resistance to embrittling, in structural materials in nuclear facilities, and also in order to protect the inner surface of tanks for hydrogen-rich fuels.

The property of these coatings, of exchanging hydrogen isotopes by fast internal diffusion at high temperature, is exploited in order to accomplish sublimation pumps capable of pumping large amounts of deuterium or of tritium in the experimental tests of plasma confinement, in order to accomplish the nuclear fusion.

Furthermore, uses as hydrogen electrodes in contact with solid electrolytes in order to accomplish such devices as solid-state gas sensors, have been reported.

In the above said applications, the usefulness is conditioned to the absolute absence of porosities in the coatings. It is also necessary that the films have a highly homogeneous composition throughout their thickness, such that internal tensions are absent, which would induce the formation of microcracks.

When these films are obtained by means of the hydrogenation of freshly deposited layers of titanium metal and are subsequently exposed to hydrogen, under the current operating conditions the limits of solubility of hydrogen in the metal ($\alpha$ phase) are locally exceeded. Therefore, such concentrations are reached, as to induce the formation of new phases (i.e., the $\gamma$ phase or the $\beta$ phase), which have a lower density than metal. The consequent increase in volume causes internal tensions to arise, which induce the formation of microcracks. This compression state of the film easily leads to the collapse of the adhesion to the substrate, with the consequent desquamation of the material.

Therefore, it is important to have available a method for obtaining hydrogenated films which are stable and homogeneous and are free from porosities or microcracks and internal tensions, and are capable of exchanging hydrogen, while retaining, in the steady state, high concentrations of hydrogen in the solid phase, without undergoing morphological and structural collapses.

Several methods exist in order to produce films of hydrogenated titanium (titanium hydride), based on the deposition of a metal film by evaporation under high vacuum and subsequent hydrogenation by interaction with hydrogen gas at high temperature.

According to as disclosed in US - A - 4 055 686, e.g., a film of titanium metal is deposited by evaporation under ultra-high vacuum ($10^{-8}$ Pa), so as to prevent any contaminations by oxygen or nitrogen. The film is then reacted with hydrogen gas at a high temperature. This method suffers has the drawbacks of it being laborious and of the needed vacuum being so high, as to limit it in its practical implementation.

FR-A-2 585 730 discloses a method of reactive sputtering in which a mixture of inert gas and hydrogen is used, in which hydrogen concentrations are comprised within the range of from 5% to 10%. Titanium in gas phase reacts With hydrogen, and deposits as titanium hydride. Under these conditions, relatively high powers are required (in the cited case, 500 W in order to deposit a film of 1 $\mu m$ of thickness within a time of about 30 minutes), in order to keep the deposition speed at a satisfactory value. Such high powers are disadvantageous in practice; furthermore, thermal transformations can be caused in the deposited material and in the substrate.

However, all of the methods described in the past, which require high temperatures in order to achieve the complete formation of stable titanium hydride, are incompatible with the coating of substrates which do not withstand high temperatures.

The present Applicant has found now that these drawbacks can be overcome by means of a process for obtaining a stable, continuous and homogeneous film of titanium hydride on a not-heated substrate, which method is based on the deposition by sputtering of titanium under an atmosphere of an inert gas and hydrogen, and on the subsequent reaction of the so obtained film with hydrogen activated by an ionic discharge.

In accordance therewith, the purpose of the present invention is a process for coating a substrate with a thin, continuous film of the hydride of a metal selected from the group consisting of titanium, palladium, vanadium, zirconium or lanthanides, which comprises the following steps carried out in succession:

(a) deposition under vacuum of a metal film by means of sputtering under an atmosphere of an inert gas containing hydrogen or hydrogen isotopes at a concentration (as expressed as hydrogen partial pressure) comprised within the range of from 0.1 to 5%;

(b) hydrogenation of the film, deposited according to the (a) step, by submitting it to the action of a cold plasma excited by an ionic discharge in an atmosphere of hydrogen or of hydrogen isotopes, containing an inert gas at a concentration (as expressed as the partial pressure of said inert gas) comprised within

2

the range of from 0 to 50%;

wherein in said (a) and (b) steps, the substrate is maintained at a temperature equal to, or lower than, 100°C.

The process is totally carried out inside one single reactor.

Under the preferred conditions, in the (a) step hydrogen, or hydrogen isotopes, are at a concentration, as expressed as their partial pressure, which is comprised within the range of from 0.5 to 4% relatively to the inert gas, in the (b) step the inert gas is absent and the temperature at which the substrated to be coated is kept, is comprised within the range of from 20°C to 70°C.

The inert gases can be helium, argon, neon, xenon. Argon is preferred.

The substrates to be coated are various, and can be metals, semiconductors, ionic conductors, glass, ceramic materials and plastic substances such as polyamides, polyimides, polyolefins, polycarbonate.

The obtained films have a thickness comprised within the range of from 0.1 to 2 $\mu$m; in case one wishes to deposit films having a thickness higher than 2 $\mu$m, the cycle constituted by the two operating steps in cascade should be advantageously repeated a plurality of times, until the desired film thickess is attained.

By means of this method, as it is better explained by means of examples in the following, films of titanium hydride are obtained which are considerably stable over time, even if they are subsequently exposed to relatively high temperatures, of up to 300°C.

The process has furthermore still another advantage, which is regarded as quite an important one: the reaction of hydride formation is carried out at a low temperature, and hence it can be applied to such substrates as plastic materials, with electrodes being e.g. obtained, which are useful in the manufacture of flexible batteries, or it can be used in order to accomplish reference electrodes by means of the direct deposition on materials for solid-state sensors.

A typical example of practical embodiment of the present invention is that which consists in using the process in order to manufacture reference electrodes for a hydrogen sensor. The solid-state sensors, useful in order to determine the concentration of a gas, in particular hydrogen, as, e.g., those reference electrodes which are described in Proc. Int. Meet. Chem. Sensors, Fulkuova (1983), are substantially constituted by 2 electrodes separated by a solid-state proton conductor. In these sensors, the reference electrode is constituted by a metal hydride selected from the group consisting of titanium hydride and zirconium hydride.

As the proton conductors, those known from technical literature, such as, e.g., zirconium hydrogen phosphate, can be used. The reference electrodes can be prepared, according to the prior art, by heating thin titanium foils for some hours at temperatures comprised within the range of from 400 to 700°C in the presence of hydrogen gas, or by means of the electrolytic treatment of the same thin foil.

Such a type of electrodes have then to be connected with the proton conductor by means of an intimate physical contact. This particular type of sensors are therefore essentially constituted by 2 electrodes in form of a thin metal foil, separated by a solid-state proton conductor constituted by zirconium hydrogen phosphate in film or membrane form.

According to the prior art, the methods for accomplishing the intimate contact between the reference electrode and the proton conductor do not secure a sufficient homogeneity and reproducibility: this causes a high impedance at the interface and therefore an instability in the response of the device.

By means of the process according to the present invention, a film of titanium hydride can be deposited, in order to act as the reference electrode, directly on one face of the proton conductor, with self-explanatory advantages as regards the homogeneity of the contact and the simplicity of manufacture of the device.

The following examples are not limitative and are reported for the purpose of better clarifying the invention.

Example 1

A thin film of titanium hydride is deposited on a slab of silicon monocrystal (111) of about 7.6 cm of diameter, by means of a process of deposition by sputtering. The equipment used is a Leybold Magnetron Sputtering Mod. Z400, fed in radiofrequency at 13.56 MHz, and equipped with a cathode of 7.3 cm of diameter, constituted by 99.9%-pure titanium metal.

Inside the deposition chamber of the equipment a vacuum higher than $10^{-4}$ Pa is made; then a gas mixture is fed, which is constituted by argon at a partial pressure of $3 \times 10^{-1}$ Pa, and hydrogen at a partial pressure of $3 \times 10^{-3}$ Pa. The argon used in the test was supplied by Rivoira and is 99.998% pure; hydrogen was supplied by Matheson, and is 99.95% pure.

The radiofrequency discharge is turned off at the power of 120 W.

In that way, the sputtering of titanium, and its deposition as titanium partially converted into titanium hydride is caused. Titanium is deposited at the speed of 0.47 nm/S (4.7 Å/second) on the substrate placed at the distance of 7 cm from the cathode.

After 50 minutes, with the discharge being still kept ignited, hydrogen is fed to the chamber until its partial pressure is of 4.5 x 10⁻¹ Pa, and the flow of argon is discontinued. After 5 minutes, the flow of hydrogen is discontinued and the discharge is turned off.

The sample is removed from the deposition chamber and the film is analysed by SIMSA spectroscopy (secondary ion mass spectroscopy) in order to verify the actual hydrogenation thereof, by comparison with a non-hydrogenated titanium film.

The counts per second relevant to hydrogen ions resulted to be $3.2 \times 10^6$, vs. a value of $1.5 \times 10^5$ of the reference sample.

After this analysis, the thickness of the film on the substrate, measured with a profilometer, resulted to be of 1.42 $\mu$m.

The composition of the film of titanium hydride, expressed as the atomic ratio of H/Ti, was determined by RBS spectroscopy (Rutherford backscattering) and ERDA analysis (Elastic recoil detection analysis) by using the scattering of $^4He^+$ ions incident on the sample with an energy of 2.2 MeV and an incidence angle of 75°.

As known, the two techniques make it possible the concentration of atoms per cm³ -- from which the stoichiometry of the hydride can be directly computed -- to be determined. In the instant case, the values of the ratio of H/Ti resulted to be comprised within the range of from 1.7 to 2.

The analysis of the film by means of small-angle X rays confirms the presence of one single phase of titanium hydride with a face-centered cubic crystal lattice, whilst non-hydrided titanium shows an hexagonal crystal lattice.

From the analyses by Auger spectroscopy, it resulted that the only impurity contained is oxygen, at a concentration lower than 1%.

Example 2

On a substrate constituted by a glass plate of 5 cm x 5 cm of dimensions a film of titanium hydride was deposited with the same equipment and according to the same process as disclosed in Example 1, but with the following modifications.

The sputtering of titanium in argon with 1% of hydrogen was carried out for 5 minutes at the power of 120 W; the hydrogenation was carried out at the power of 100 W for a time of 10 minutes. Furthermore, the process was repeated twice. Under these conditions, a film of 0.75 $\mu$m was obtained. The hydrogenation, measured by means of the same techniques as disclosed in Example 1, reached the value of $10^7$ counts per second, with a constant depth profile.

The analysis at the scanning electron microscope (SEM) showed a homogeneous film free from microcracks and perfectly adherent to the glass.

Example 3

On a silicon substrate and on a glass substrate a film of titanium hydride is deposited by means of the same process as of Example 1, but with the following modifications: the (a) step is carried out in the absence of hydrogen.

Under these conditions, both of said films, during the (b) step, got detached from both of their substrates.

Example 4

By using the same procedure as of Example 2, with the difference that deuterium is used in lieu of hydrogen, a film of 0.6 $\mu$m of deuterated titanium can be obtained.

The SIMS analysis of the so obtained sample demonstrated that the deuteration took place. The counts of $D^+$ reach in fact the value of $3.3 \times 10^6$ counts per second, whilst hydrogen does not exceed the value of $1.5 \times 10^5$ counts per seconds, like in the reference sample.

Example 5

Two samples, "A" and "B", respectively prepared as disclosed in Examples 1 and 2, were left standing at room temperature for 120 days before their hydrogen content was measured by means of SIMS techniques. For comparison, the "C" sample was used, which was prepared by exposing a titanium film to hydrogen gas at the pressure of 70 Pa, and at the temperature of 450°C. The hydrogenation, as measured according to the same techniques as of Example 1, gave the following results:

| Sample | Time (days) | Counts/second |
|--------|-------------|---------------|
| A | 0 | $3.2 \times 10^6$ |
|   | 120 | $3.3 \times 10^6$ |
| B | 0 | $9.1 \times 10^6$ |
|   | 120 | $9.0 \times 10^6$ |
| C | 0 | $2.4 \times 10^6$ |
|   | 120 | $1.6 \times 10^6$ |

One can see that the samples prepared by means of the instant method, stored at room temperature, retain their hydrogenation level still after 4 months, whilst the comparative "C" sample, obtained according to the traditional techniques, lost 30% of its counts rate.

In order to further verify the stability of the hydrides, the "A" and "B" samples were submitted to heating for 4.5 hours at 150°C and for 1 hour at 240°C. Also under these conditions, the hydride concentration remained practically unchanged, as demonstrated by the values of $3.1 \times 10^6$ and $8.9 \times 10^6$ counts per second, respectively shown by "A" and "B" samples.

Example 6

A thin plate of polycarbonate, a sheet of Mylar and a sheet of Kapton, all of 7 cm x 5 cm, were ultrasonically cleaned with isopropanol and were dried with an air stream.

On the samples a layer of titanium hydride of 0.7 $\mu$m of thickness was deposited by using the same technique as disclosed in Example 2.

The adhesion of the coating was tested according to the "Scotch tape test (K.L. Mittal, "Adhesion Measurements", ASTM, Philadelphia 1978, p. 217), by using a 3M 810 adhesive tape and repeating the test three times on the same point. All of the samples passed the adhesion test.

Example 7

In this example, an application of the instant invention is disclosed in the preparation of solid-state sensors for hydrogen measurements.

The sensor consists of an electrolytic cell constituted by a solid electrolyte, viz., zirconium hydrogen phosphate; a platinum electrode, and a second electrode of titanium hydride.

The crystalline zirconium hydrogen phosphate is regenerated by means of the addition of diluted HCl to a colloidal suspension of 1 g of phosphate in 250 ml of water. By filtration on filter paper, the film is obtained, which is constituted by orientated laminar crystals.

On one face of the film, a platinum film is directly deposited by sputtering. On the other face, the elctrode of titanium hydride is directly deposited by means of the following procedure.

Inside a chamber for deposition by sputtering, a vacuum higher than $10^{-4}$ Pa is made; then a gas mixture is fed, which is constituted by argon at a partial pressure of $3 \times 10^{-1}$ Pa, and hydrogen at a partial pressure of $6 \times 10^{-3}$ Pa.

The radiofrequency discharge is ignited at the power of 100 W, so as to cause the sputtering of titanium, and the deposition of said titanium on the substrate as hydrogenated titanium. Titanium is deposited at the speed of 0.47 nm/S (4.7 Å/second).

After 50 minutes, with the discharge being still kept ignited, hydrogen is fed to the sputtering chamber until its partial pressure is of $4.5 \times 10^{-1}$ Pa, and the flow of argon is discontinued. After 5 minutes, the flow of hydrogen is discontinued and the discharge is turned off.

In this way, a film of titanium hydride of 1.4 $\mu$m of thickness is formed.

Finally onto both of the conductor layers, the electrical contacts are deposited in order to complete the device.

For comparative purposes, an analogous device was prepared, in which the electrode is constituted by a thin plate of titanium hydrogenated by an electrolytic process, for 20 hours in 2 N sulfuric acid, under a voltage of 1.1 V and with a current of 135 mA/cm². The hydrogenated thickness resulted to be of 5 $\mu$m.

In Tables 1 and 2 the values of the electrical potential of the cell (mV) is reported, for both of said sensors, as a function of the logarithm of the partial pressure of hydrogen (as atmospheres).

Table 1 relates to the sensor with the cathode constituted by titanium hydride according to the present invention, and the sets of measurements I, II, III, IV were carried out in succession by alternatively increasing and decreasing the partial pressure of hydrogen in mixture with air. Table 2 relates to the sensor with the cathode of electrolytically hydrogenated titanium, and the series of measurements I, II, III, IV were carried out in succession by alternatively increasing and decreasing the partial pressure of hydrogen in mixture with air.

As one can see, only the sensor with the electrode accomplished according to the instant invention has a good reproducibility, within a deviation of 5%.

Inasmuch as the value of the voltage reading depends on the partial pressure of hydrogen gas and on the reference voltage generated by the electrode of titanium hydride, with the partial pressure of hydrogen being the same, the deviations observed in Table 2 are due to variations in the characteristics of the electrode of titanium hydride.

### Table 1

| $\log P(H_2)$ | Sets of measurements | | | |
| --- | --- | --- | --- | --- |
| | I | II | III | IV |
| -3.2 | 80 | 85 | 78 | 83 |
| -3.45 | 115 | 120 | 110 | 111 |
| -3.7 | 152 | 144 | 160 | 157 |
| -4.05 | 180 | 186 | 182 | 172 |
| -4.2 | 220 | 230 | 205 | 210 |
| -4.75 | 275 | 267 | 280 | 270 |

### Table 2

| $\log P(H_2)$ | Sets of measurements | | | |
| --- | --- | --- | --- | --- |
| | I | II | III | IV |
| -3 | 303 | - | - | - |
| -3.7 | 181 | - | - | - |
| -4.3 | - | 217 | - | 350 |
| -4.4 | - | 200 | - | 352 |
| -4.7 | - | - | - | 354 |
| -5 | 142 | 128 | 160 | 334 |

## Claims

**Claims for the following Contracting States : AT, BE, CH, DE, DK, FR, GB, LI, LU, NL, SE**

1.   Process for coating a substrate with a thin, continuous film of the hydride of a metal selected from the group consisting of titanium, palladium, vanadium, zirconium , which comprises the following steps carried out in succession:
  (a) deposition under vacuum of a metal film by means of sputtering under an atmosphere of an inert gas containing hydrogen or hydrogen isotopes in a concentration (as expressed as hydrogen partial pressure) comprised within the range of from 0.01 to 5%;

(b) hydrogenation of the film, deposited according to the (a) step, by submitting it to the action of a cold plasma excited by an ionic discharge in an atmosphere of hydrogen or of hydrogen isotopes, containing an inert gas at a concentration (as expressed as the partial pressure of said inert gas) comprised within the range of from 0 to 50%;

wherein in said (a) and (b) steps, the substrate is maintained at a temperature equal to, or lower than, 100°C.

2. Process according to claim 1, wherein the metal is titanium.

3. Process according to claim 1, wherein the inert gas is argon.

4. Process according to claim 1, wherein the inert gas in the (b) step is at a concentration (as expressed as the partial pressure of said inert gas) of 0%.

5. Process according to claim 1, wherein in the (a) step hydrogen or hydrogen isotopes, are at a concentration (as expressed as their partial pressure) comprised within the range of from 0.5 to 4%.

6. Process according to claim 1, wherein the hydrogen isotope is deuterium in the gas state.

7. Process according to claim 1, wherein the substrate is maintained at a temperature comprised within the range of from 20 to 70°C.

8. Process according to claims from 1 to 7, wherein the cycle consisting of the steps carried out in the above (a) and (b) sequence is repeated a plurality of times.

9. Process according to claims from 1 to 8, wherein the substrate is made from plastic material.

10. Use of the process according to claims from 1 to 8 in order to deposit films of titanium hydride as a protective coating for structural materials in nuclear facilities.

11. Use of the coated substrate made according to the process of claims from 1 to 8 as a reference electrode in solid-state sensors which comprise a reference electrode coupled with a measuring electrode by means of a proton conductor.

## Claims for the following Contracting States : ES, GR

1. Process for coating a substrate with a thin, continuous film of the hydride of a metal selected from the group consisting of titanium, palladium, vanadium, zirconium , characterized in that it comprises the following steps carried out in succession:

(a) deposition under vacuum of a metal film by means of sputtering under an atmosphere of an inert gas containing hydrogen or hydrogen isotopes in a concentration (as expressed as hydrogen partial pressure) comprised within the range of from 0.01 to 5%;

(b) hydrogenation of the film, deposited according to the (a) step, by submitting it to the action of a cold plasma excited by an ionic discharge in an atmosphere of hydrogen or of hydrogen isotopes, containing an inert gas at a concentration (as expressed as the partial pressure of said inert gas) comprised within the range of from 0 to 50%;

wherein in said (a) and (b) steps, the substrate is maintained at a temperature equal to, or lower than, 100°C.

2. Process according to claim 1, characterized in that the metal is titanium.

3. Process according to claim 1, characterized in that the inert gas is argon.

4. Process according to claim 1, characterized in that the inert gas in the (b) step is at a concentration (as expressed as the partial pressure of said inert gas) of 0%.

5. Process according to claim 1, characterized in that in the (a) step hydrogen or hydrogen isotopes, are at a concentration (as expressed as their partial pressure) comprised within the range of from 0.5 to 4%.

7

6. Process according to claim 1, characterized in that the hydrogen isotope is deuterium in the gas state.

7. Process according to claim 1, characterized in that the substrate is maintained at a temperature comprised within the range of from 20 to 70°C.

8. Process according to claims from 1 to 7, characterized in that the cycle consisting of the steps carried out in the above (a) and (b) sequence is repeated a plurality of times.

9. Process according to claims from 1 to 8, characterized in that the substrate is made from plastic material.

**Patentansprüche**

**Patentansprüche für folgende Vertragsstaaten : AT, BE, CH, DE, DK, FR, GB, LI, LU, NL, SE**

1. Verfahren zur Beschichtung eines Substrates mit einem dünnen, kontinuierlichen Film aus dem Hydrid eines Metalles, welches von der aus Titan, Palladium, Vanadium, Zirconium bestehenden Gruppe ausgewählt ist, welches Verfahren die folgenden nacheinander auszuführenden Schritte umfaßt:
   (a) Aufdampfen eines Metallfilmes unter Vakuum mittels Sputtering unter einer Atmosphäre aus einem Inertgas, welches Wasserstoff oder Wasserstoffisotope in einer Konzentration (ausgedrückt als Wasserstoffpartialdruck) im Bereich von 0,01 bis 5% umfaßt;
   (b) Hydrieren des gemäß Schritt (a) aufgedampften Filmes durch Unterwerfen dieses Filmes unter die Wirkung eines kalten Plasmas, welches durch eine ionische Entladung in einer Atmosphäre aus Wasserstoff oder Wasserstoffisotopen gebildet wird, welche ein Inertgas in einer Konzentration (ausgedrückt als Partialdruck des genannten Inertgases) im Bereich von 0 bis 50% enthält;
   worin in den genannten Schritten (a) und (b) das Substrat bei einer Temperatur von 100°C oder darunter gehalten wird.

2. Verfahren nach Anspruch 1, worin das Metall Titan ist.

3. Verfahren nach Anspruch 1, worin das Inertgas Argon ist.

4. Verfahren nach Anspruch 1, worin das Inertgas im Schritt (b) in einer Konzentration (ausgedrückt als Partial des genannten Inertgases) von 0% vorliegt.

5. Verfahren nach Anspruch 1, worin im Schritt (a) der Wasserstoff oder die Wasserstoffisotope in einer Konzentration (ausgedrückt als deren Partialdruck) im Bereich von 0,5 bis 4% vorliegen.

6. Verfahren nach Anspruch 1, worin das Wasserstoffisotop Deuterium im gasförmigen Zustand ist.

7. Verfahren nach Anspruch 1, worin das Substrat bei einer Temperatur im Bereich von 20 bis 70°C gehalten wird.

8. Verfahren nach den Ansprüchen 1 bis 7, worin der Zyklus, welcher aus den Schritten (a) und (b) besteht, die in der vorstehen Reihenfolge ausgeführt werden, mehrmals wiederholt wird.

9. Verfahren nach den Ansprüchen 1 bis 8, worin das Substrat aus Kunststoffmaterial besteht.

10. Verwendung des Verfahrens nach den Ansprüchen 1 bis 8 zur Aufdampfung von Filmen aus Titanhydrid als schützende Beschichtung für Baumaterial in kerntechnischen Anlagen.

11. Verwendung des nach dem Verfahren der Ansprüche 1 bis 8 hergestellten beschichteten Substrates als Referenzelektrode in Festkörpersensoren, welche eine Referenzelektrode umfassen, die mittels eines Protonenleiters mit einer Meßelektrode verbunden ist.

**Patentansprüche für folgende Vertragsstaaten : ES, GR**

1. Verfahren zur Beschichtung eines Substrates mit einem dünnen, kontinuierlichen Film aus dem Hydrid eines Metalles, welches von der aus Titan, Palladium, Vanadium, Zirconium bestehenden Gruppe ausgewählt ist, dadurch gekennzeichnet, daß es die folgenden nacheinander auszuführenden Schritte umfaßt:

(a) Aufdampfen eines Metallfilmes unter Vakuum mittels Sputtering unter einer Atmosphäre aus einem Inertgas, welches Wasserstoff oder Wasserstoffisotope in einer Konzentration (ausgedrückt als Wasserstoffpartialdruck) im Bereich von 0,01 bis 5% umfaßt;

(b) Hydrieren des gemäß Schritt (a) aufgedampften Filmes durch Unterwerfen dieses Filmes unter die Wirkung eines kalten Plasmas, welches durch eine ionische Entladung in einer Atmosphäre aus Wasserstoff oder Wasserstoffisotopen gebildet wird, welche ein Inertgas in einer Konzentration (ausgedrückt als Partialdruck des genannten Inertgases) im Bereich von 0 bis 50% enthält;

worin in den genannten Schritten (a) und (b) das Substrat bei einer Temperatur von 100°C oder darunter gehalten wird.

2. Verfahren nach Anspruch 1, dadurch gekennzeichnet, daß das Metall Titan ist.

3. Verfahren nach Anspruch 1, dadurch gekennzeichnet, daß das Inertgas Argon ist.

4. Verfahren nach Anspruch 1, dadurch gekennzeichnet, daß das Inertgas im Schritt (b) in einer Konzentration (ausgedrückt als Partialdruck des genannten Inertgases) von 0% vorliegt.

5. Verfahren nach Anspruch 1, dadurch gekennzeichnet, daß im Schritt (a) der Wasserstoff oder die Wasserstoffisotope in einer Konzentration (ausgedrückt als deren Partialdruck) im Bereich von 0,5 bis 4% vorliegen.

6. Verfahren nach Anspruch 1, dadurch gekennzeichnet, daß das Wasserstoffisotop Deuterium im gasförmigen Zustand ist.

7. Verfahren nach Anspruch 1, dadurch gekennzeichnet, daß das Substrat bei einer Temperatur im Bereich von 20 bis 70°C gehalten wird.

8. Verfahren nach den Ansprüchen 1 bis 7, dadurch gekennzeichnet, daß der Zyklus, welcher aus den Schritten (a) und (b) besteht, die in der vorstehenden Reihenfolge ausgeführt werden, mehrmals wiederholt wird.

9. Verfahren nach den Ansprüchen 1 bis 8, dadurch gekennzeichnet, daß das Substrat aus Kunstoffmaterial besteht.

## Revendications

**Revendications pour les Etats contractants suivants : AT, BE, CH, DE, DK, FR, GB, LI, LU, NL, SE**

1. Procédé de revêtement d'un substrat avec un film continu mince de l'hydrure d'un métal choisi parmi le titane, le palladium, le vanadium et le zirconium, qui comprend les étapes suivantes, effectuées dans l'ordre :

(a) dépôt sous vide d'un film de métal, par pulvérisation dans une atmosphère d'un gaz inerte renfermant de l'hydrogène ou des isotopes de l'hydrogène à une concentration (exprimée en pression partielle d'hydrogène) comprise dans l'intervalle allant de 0,01 à 5 %,

(b) hydrogénation du film déposé conformément à l'étape (a), par soumission dudit film à l'action d'un plasma froid, excité par une décharge ionique dans une atmosphère d'hydrogène ou d'isotopes de l'hydrogène, renfermant un gaz inerte à une concentration (exprimée en pression partielle dudit gaz inerte) comprise dans l'intervalle allant de 0 à 50 %,

le substrat étant maintenu à une température égale ou inférieure à 100°C dans lesdites étapes (a) et (b).

2. Procédé selon la revendication 1, dans lequel le métal est le titane.

3. Procédé selon la revendication 1, dans lequel le gaz inerte est l'argon.

4. Procédé selon la revendication 1, dans lequel, dans l'étape (b), le gaz inerte est à une concentration (exprimée en pression partielle dudit gaz inerte) de 0 %.

5. Procédé selon la revendication 1, dans lequel, dans l'étape (a), l'hydrogène ou les isotopes de l'hydrogène sont à une concentration (exprimée en leur pression partielle) comprise dans l'intervalle allant de 0,5 à 4 %.

6. Procédé selon la revendication 1, dans lequel l'isotope de l'hydrogène est le deutérium à l'état gazeux.

7. Procédé selon la revendication 1, dans lequel le substrat est maintenu à une température comprise dans l'intervalle allant de 20 à 70°C.

8. Procédé selon les revendications 1 à 7, dans lequel le cycle constitué des étapes effectuées dans la séquence (a) et (b) précédente, est répété à plusieurs reprises.

9. Procédé selon les revendications 1 à 8, dans lequel le substrat est constitué d'une matière plastique.

10. Utilisation du procédé selon les revendications 1 à 8, pour le dépôt de film d'hydrure de titane en tant que revêtement protecteur pour des matériaux de construction dans des installations nucléaires.

11. Utilisation du substrat revêtu, préparé par le procédé des revendications 1 à 8, en tant qu'électrode de référence dans des détecteurs à l'état solide, qui comprennent une électrode de référence associée à une électrode de mesure au moyen d'un conducteur de protons.

**Revendications pour les Etats contractants suivants : ES, GR**

1. Procédé de revêtement d'un substrat avec un film continu mince de l'hydrure d'un métal choisi parmi le titane, le palladium, le vanadium et le zirconium, **caractérisé** en ce qu'il comprend les étapes suivantes, effectuées dans l'ordre :
   (a) dépôt sous vide d'un film de métal, par pulvérisation dans une atmosphère d'un gaz inerte renfermant de l'hydrogène ou des isotopes de l'hydrogène à une concentration (exprimée en pression partielle d'hydrogène) comprise dans l'intervalle allant de 0,01 à 5 %,
   (b) hydrogénation du film déposé conformément à l'étape (a), par soumission dudit film à l'action d'un plasma froid, excité par une décharge ionique dans une atmosphère d'hydrogène ou d'isotopes de l'hydrogène, renfermant un gaz inerte à une concentration (exprimée en pression partielle dudit gaz inerte) comprise dans l'intervalle allant de 0 à 50 %,
   le substrat étant maintenu à une température égale ou inférieure à 100°C dans lesdites étapes (a) et (b).

2. Procédé selon la revendication 1, **caractérisé** en ce que le métal est le titane.

3. Procédé selon la revendication 1, **caractérisé** en ce que le gaz inerte est l'argon.

4. Procédé selon la revendication 1, **caractérisé** en ce que, dans l'étape (b), le gaz inerte est à une concentration (exprimée en pression partielle dudit gaz inerte) de 0 %.

5. Procédé selon la revendication 1, **caractérisé** en ce que, dans l'étape (a), l'hydrogène ou les isotopes de l'hydrogène sont à une concentration (exprimée en leur pression partielle) comprise dans l'intervalle allant de 0,5 à 4 %.

6. Procédé selon la revendication 1, **caractérisé** en ce que l'isotope de l'hydrogène est le deutérium à l'état gazeux.

7. Procédé selon la revendication 1, **caractérisé** en ce que le substrat est maintenu à une température comprise dans l'intervalle allant de 20 à 70°C.

8. Procédé selon les revendications 1 à 7, **caractérisé** en ce que le cycle constitué des étapes effectuées dans la séquence (a) et (b) précédente, est répété à plusieurs reprises.

9. Procédé selon les revendications 1 à 8, **caractérisé** en ce que le substrat est constitué d'une matière plastique.